Europäisches Patentamt

European Patent Office

Office européen des brevets

(11) Publication number: 0 496 383 A2

# EUROPEAN PATENT APPLICATION

(21) Application number: 92101024.5

(22) Date of filing: 22.01.92

(51) Int. Cl.5: **G06F 3/033**, G06F 1/32

(30) Priority: 22.01.91 JP 22805/91
08.02.91 JP 39578/91

(43) Date of publication of application:
**29.07.92 Bulletin 92/31**

(84) Designated Contracting States:
**DE FR GB NL**

(71) Applicant: **SONY CORPORATION**
7-35, Kitashinagawa 6-chome Shinagawa-ku
Tokyo(JP)

(72) Inventor: **Takahara, Hideki**
c/o Sony Corporation, 7-35 Kitashinagawa
6-chome
Shinagawa-ku Tokyo(JP)
Inventor: **Sugimoto, Mitsuaki**
c/o Sony Corporation, 7-35 Kitashinagawa
6-chome
Shinagawa-ku Tokyo(JP)
Inventor: **Takano, Toshio**
c/o Sony Corporation, 7-35 Kitashinagawa
6-chome
Shinagawa-ku Tokyo(JP)

(74) Representative: **Körber, Wolfhart, Dr. Dipl.-Ing.
et al**
**Patentanwälte Mitscherlich & Partner
Steinsdorfstrasse 10
W-8000 München 22(DE)**

(54) **Data input and display apparatus.**

(57) A data input and display apparatus comprising a tablet (21) to which an information signal is inputted by designating a coordinate position, a display circuit (42a, 42b, 43) for generating a display signal in accordance with the information signal inputted from the tablet (21), a display member (22) capable of visually representing the display signal, a control circuit (46) for generating a control signal by detecting the presence of any input to the tablet (21), a light source (26) for illuminating the display member (22) from behind, a light source controller (63) for controlling the light source (26) in response to the control signal generated from the control circuit (46), a power circuit (64) for obtaining a driving voltage from a voltage source, a means (905, 914) for detecting the state of the voltage source, and a luminance control means (915) for controlling the luminance of the light source (26) in response to the output of the detecting means (905, 914). The power circuit (64) is capable of selecting either a first voltage produced by rectifying an AC power supply (17), or a second voltage obtained from a battery (19).

FIG. 5

# BACKGROUND OF THE INVENTION

## 1. Field of the Invention

The present invention relates to a data input and display apparatus for controlling an input-output panel adapted for use in an electronic appliance such as a portable personal computer (electronic notebook) or a word processor.

## 2. Description of the Prior Art

It has been known heretofore that a liquid crystal display unit is employed as a display means on a panel of a portable electronic notebook, personal computer, word processor or the like. And a back light (or a side light) is provided behind (or beside) the liquid crystal display unit to illuminate the display face for enabling a user to see the visual representation with facility.

Such a portable computer or the like is designed to be operable on a battery power supply also so as to be usable in any place where a commercial power source is not available. However, if the liquid crystal display (LCD) unit is illuminated with a back light energized by a battery, a considerably great amount of electric power is consumed to consequently shorten the service life of the battery. For eliminating such a disadvantage, there is known an improved apparatus where a back light is automatically switched off when a keyboard is not manipulated for more than a predetermined time. In this apparatus, the back light is switched on again if a desired input enters from the keyboard in the off-state of the back light. Thus, unnecessary consumption of the battery power is rendered preventable.

However, the liquid crystal panel incorporated in any conventional portable computer (electronic notebook, personal computer, word processor or the like) is equipped merely with a display function, so that it is impossible to execute direct input on the panel. Although there is available a type having a combination of a liquid crystal display unit and a tablet to achieve direct input on the panel, the display face is dark due to sole utilization of external light, whereby some difficulties are rendered unavaoidable in an input manipulation.

It is customary that a portable personal computer or the like can be furnished with a battery pack in addition to a commercial power supply so as to be usable outdoors as well. However, in an operation with such a battery pack, the usable time is limited by the capacity of the battery.

Furthermore, in any small portable computer not equipped with a keyboard, it is impossible to switch on a back light again from an off-state by manipulation of a keyboard. Therefore, an additional switch may be provided for turning on the back light again from the off-state thereof caused as a result of no input for a predetermined time. In such constitution, however, the required component elements come to be numerically increased to raise the production cost with another demerit of difficulty in realizing a dimensional reduction of the apparatus structure.

## OBJECTS AND SUMMARY OF THE INVENTION

The present invention has been accomplished in an attempt to eliminate the problems in the prior art mentioned above. And its one object resides in providing an improved data input and display apparatus which is capable of facilitating an input manipulation by illuminating a panel with another advantage of supperssing unnecessary power consumption when furnished with a battery pack.

And another object of the present invention resides in an improvement for enabling any apparatus, which is not equipped with a keyboard, to prevent wasteful power consumption without a dimensional increase in structure while averting the necessity of a larger number of component elements.

According to one aspect of the present inveition, there is provided a data input and display apparatus comprising a tablet to which an information signal is inputted by designating a coordinate position, a display circuit for generating a display signal in accordance with the information signal inputted from the tablet, a display member capable of visually representing the display signal, a control circuit for generating a control signal by detecting the presence of any input to the tablet, a light source for illuminating the display circuit from behind, and a light source controller for controlling the light source in response to the control signal generated from the control circuit.

According to another aspect of the present invention, there is provided a data input and display apparatus comprising an input means for inputting an information signal, a display circuit for generating a display signal in accordance with the information signal obtained from the input means, a display member capable of visually representing the display signal, a control circuit for generating a control signal by detecting the presence of any input to the input means, a light source for illuminating the display circuit from behind, a light source controller for controlling the light source in response to the control signal generated from the control circuit, a power circuit for obtaining a driving voltage from a voltage source, a means for detecting the state of the voltage source, and a luminance control means for controlling the luminance of the light source in response to the output of the detecting means, wherein the power circuit is capable of selecting, as the voltage source, either a first voltage produced by rectifying an AC power supply, or a second voltage obtained from a battery.

The above and other features and advantages of the present invention will become apparent from the following description which will be given with reference to the illustrative accompanying drawings.

## BRIEF DESCRIPTION OF THE DRAWINGS

Fig. 1 is a perspective view of an exemplary embodiment with the data input and display apparatus of the present invention applied to a portable computer;

Fig. 2 is a sectional view showing the structure of an input screen in the embodiment of Fig. 1;

Fig. 3 is a sectional view of an exemplary fluorescent EL plate employed in Fig. 2;

Fig. 4 is a block diagram showing the relationship of electrical connection between an LCD unit and a tablet in Fig. 1;

Fig. 5 is a block diagram showing the entire electrical constitution in the embodiment of Fig. 1;

Fig. 6 is a perspective view of the vicinity of a battery loading compartment in a main body of the embodiment of Fig. 1;

Fig. 7 (Figs. 7A and 7B) is a perspective view of the vicinity of the battery loading compartment with a battery removed therefrom in the main body of the embodiment of Fig. 1;

Fig. 8 is a perspective exterior view of an exemplary battery used in the embodiment of Fig. 1;

Fig. 9 is a perspective exterior view of another battery used in the embodiment of Fig. 1;

Fig. 10 is a perspective exterior view of a primary battery used in the embodiment of Fig. 1;

Fig. 11 is a bottom view of the primary battery used in the embodiment of Fig. 1;

Fig. 12 is a block diagram showing the relationship of electrical connection between a battery and a fluorescent EL plate in the embodiment of Fig. 1;

Fig. 13 illustrates an exemplary display on a screen in the embodiment of Fig. 5;

Fig. 14 illustrates another exemplary display on the screen in the embodiment of Fig. 5;

Fig. 15 (Figs. 15A and 15B) is a flow chart to explain the operation performed in the embodiment of Fig. 5; and

Fig. 16 is another flow chart to explain the operation performed in the embodiment of Fig. 5.

## DESCRIPTION OF THE PREFERRED EMBODIMENT

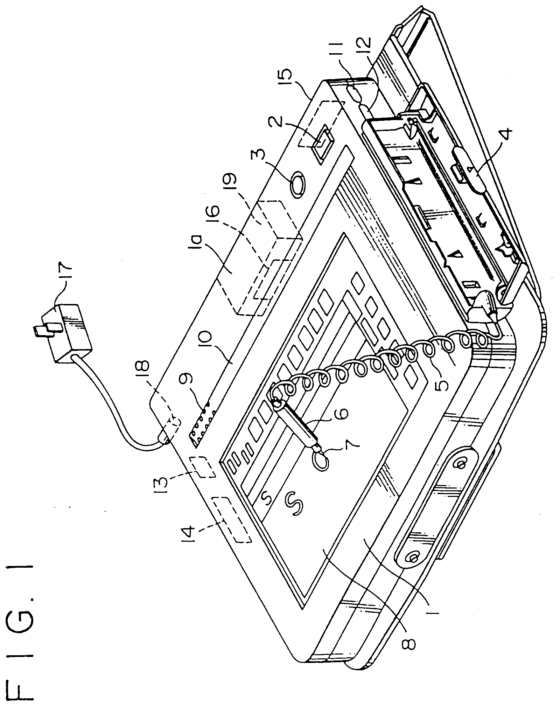

Fig. 1 is a perspective view of a preferred embodiment which represents an example of applying the data input and display apparatus of the present invention to an electronic notebook (portable computer). A main body 1 is equipped with a power switch 2 which is turned on when using the apparatus or is turned off for halting the use. Adjacent to the left of the power switch 2, there is provided a luminance adjust switch 3 for adjusting the luminance of a display screen 8 (luminance of an undermentioned LCD unit 22). A case 4 is disposed on one side of the main body 1. In the case 4 is housed, when not in use, a pen 6 having a switch 7 at its fore end and connected via a cord 5 to the main body 1. The pen 6 is so contrived, when taken out of the case 4, as to be placeable in a groove 10 formed horizontally in an upper portion of the main body 1. And at the left of the groove 10, there is disposed a speaker 9 for outputting a predetermined sound.

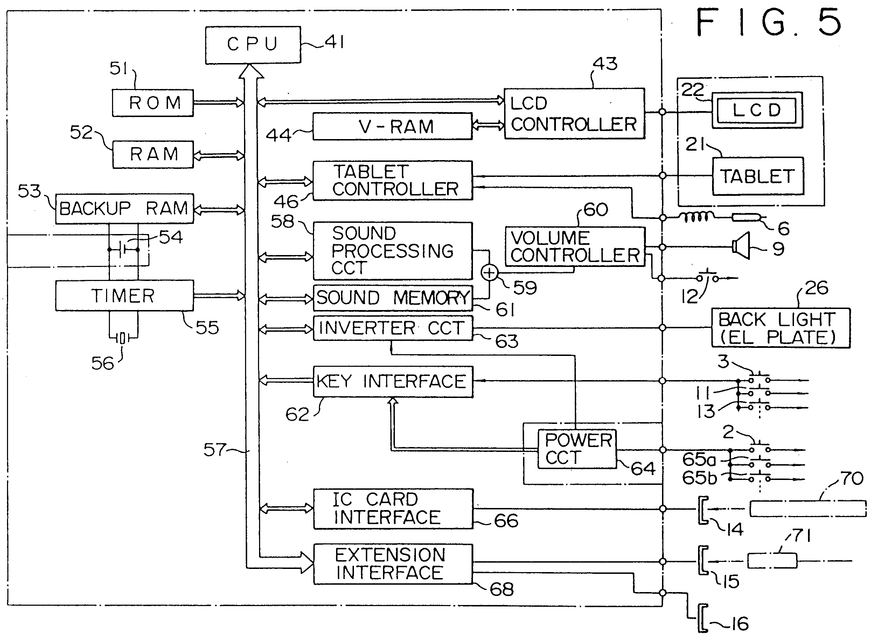

Two switches 11, 12 are provided in an upper portion on the right side of the main body 1. The switch 11 is used for selectively changing the luminous intensity of an undermentioned back light in two steps for example, and the switch 12 is used for selectively changing, in three steps for example, the volume of the sound outputted from the speaker 9. Another switch 13 provided on the left side of the main body 1 is actuated for interrupting a predetermined operation (e.g., for interrupting the sound being emitted). Also on the left side of the main body 1, there is disposed a socket 14 where a memory IC card 70 (Fig. 5) is loaded. And a socket 15 is provided in a rear portion of the main body 1. Furthermore, another socket 16 is provided in a battery compartment 1a formed in a rear portion of the main body 1 for housing a battery 19. The sockets 15, 16 are so arranged that a cable (e.g. RS232C), a modem, an adaptor and so forth are connectable thereto. And a connection terminal 18 for an AC adaptor 17 is provided in an upper portion on the left side of the main body 1.

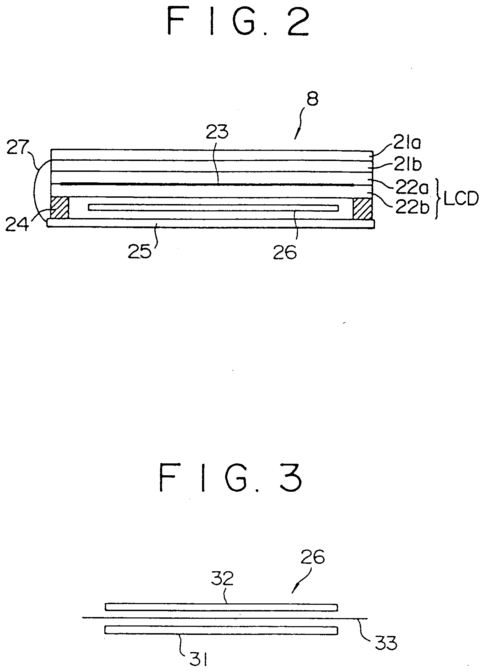

Fig. 2 illustrates an exemplary structure of the display screen 8 in detail. In this embodiment, a tablet 21 (consisting of a tablet 21a for detection of an X-axis position and a tablet 21b for detection of a Y-axis position) is disposed at the top, and an LCD (liquid crystal display) unit 22 is positioned under the tablet 21. The LCD unit 22 consists of upper and lower glass sheets 22a, 22b and a liquid crystal 23 inserted therebetween. And a fluorescent EL plate 26 is disposed under the LCD unit 22. When light is emitted from the fluorescent EL plate 26 serving as a back light, the output light illuminates the LCD unit 22. Since the tablets 21a, 21b are both composed of a transparent material, an image displayed by the liquid crystal 23 can be observed from above in the drawing. Unshown component elements are mounted on a printed circuit board (PCB) 25, which is electrically connected to the LCD unit 22 via a rubber connector 24 while being electrically connected also to the tablet 21 through a conductive film 27.

Fig. 3 shows a detailed structure of the fluorescent EL plate 26. In this embodiment, an insulator film 33 is interposed between an electrode 31 and a light emitter (another electrode) 32, so that when a predetermined voltage is applied between the electrode 31 and the light emitter 32, a light output is produced from the energized emitter 32. Each of the electrode 31 and the light emitter 32 is shaped into a plate so as to be capable of illuminating the screen 8 uniformly.

The back light may be composed of a suitable fluorescent tube as well. It is also possible to provide a fluorescent tube as a side light on one side of the main body for illuminating the screen by transmission of a light output therefrom to a rear portion of the LCD unit 22 through a light transmitting member.

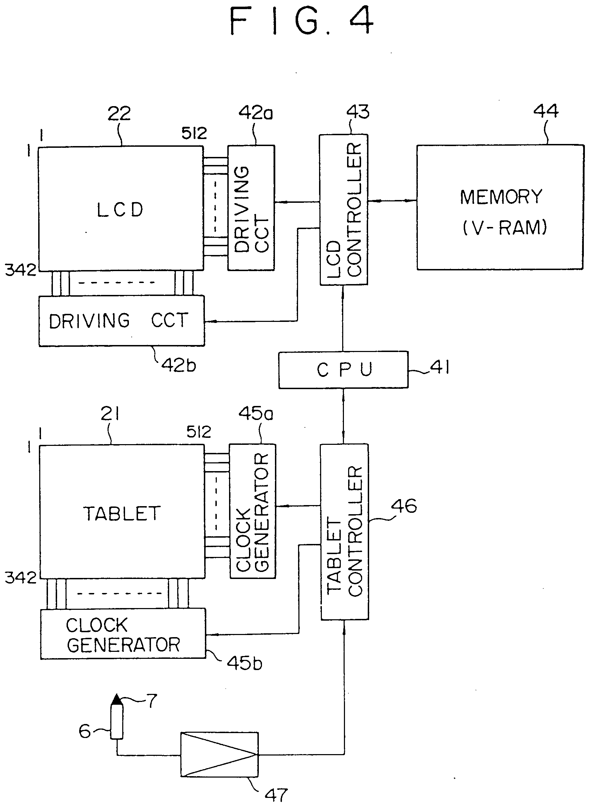

Fig. 4 is a circuit diagram showing the principle of positional detection executed by the tablet and that of display by the LCD unit. The tablet 21 has, e.g., 512 electrodes in the X-axis direction and 342 electrodes in the Y-axis direction to realize detection of 512 x 342 pixels. A tablet controller 46 controls a clock generator 45a so that a predetermined voltage is applied sequentially to each of the 342 electrodes. Subsequently another clock generator 45b is controlled, and a predetermined voltage is applied sequentially to each of the 512 electrodes. Consequently, the tablets 21 are scanned by clock signals obtained from the clock generators 45a and 45b. With an approach of the pen 6 to a desired position on the tablet 21, a predetermined electrostatic capacity is formed between the tablet 21 and the pen 6. And when the pen 6 is depressed to the tablet 21, the switch 7 disposed at the fore end of the pen 6 is turned on to thereby detect the static charge generated between the pen 6 and the relevant electrode on the tablet 21, and the detected charge is supplied via an amplifier 47 to the tablet controller 46. Since the tablet controller 46 functions to control the timing to generate clock signals from the clock generators 45a and 45b, it is possible to detect the position depressed by the pen 6 on the tablet 21 in accordance with both the detection signal supplied from the pen 6 and the clock signal generation timing. Thereafter the tablet controller 46 supplies to a CPU 41 the operational coordinates thus detected by the pen 6. The CPU 41 keeps monitoring both the pen-down position where the pen 6 is pressed to the tablet 21 to turn on the switch 7, and the pen-up position where the pen 6 is separated upward from the tablet 21 to turn off the switch 7. The input is received in response to the pen-down action and is decided in response to the pen-up action.

The CPU 41 controls an LCD controller 43 and writes data, which correspond to an image to be displayed, in a memory (V-RAM) 44. The LCD controller 43 reads the data from the memory 44 and supplies to a driving circuit 42b a signal corresponding to the data. The LCD unit 22 has 512 horizontal electrodes and 342 vertical electrodes correspondingly to the tablet 21. And the driving circuit 42a serves to apply a predetermined voltage sequentially to each of the 342 electrodes. Meanwhile the driving circuit 42b serves to apply a predetermined voltage sequentially to each of the 512 electrodes. Thus the individual pixels on the LCD unit 32 are scanned, and a desired image is displayed on the LCD unit 22.

Fig. 5 shows a further detailed electric constitution in the main body 1. The CPU 41 is connected to various ICs and so forth via a bus line 57. In a ROM 51, there are stored a system program for the entire apparatus, a kana-kanji character conversion program for a word processing function, a dictionary table therefor, a recognition program for a manual write input, a dictionary table therefor and so forth. In a working RAM 52 is stored, when necessary, data needed for the operation. A backup battery 54 (different from the aforementioned battery 19) is connected to a backup RAM 53 so that the required data can be backed up even in case the power supply for the main body of the apparatus is accidentally turned off. A timer IC 55 is connected to the backup battery 54 and counts clock pulses obtained from a quartz vibrator 56, thereby outputting the data of a date and a time at the counting instant. The LCD controller 43 and the tablet controller 46 mentioned above are also connected to the CPU 41 via the bus line 57.

A sound processing circuit 58 generates a predetermined sound signal in response to an input command from any of the sockets 14 through 16 or the CPU 41 and transmits such sound signal to an adder 59. A sound memory 61 is controlled by the CPU 41 and transmits a stored sound (e.g. a warning sound "eh ?") to the adder 59. Then the adder 59 adds the output of the wound processing circuit 58 to the output of the sound memory 61, and transmits the result of such addition to the speaker 9 via a sound volume controller 60. The sound volume can be controlled by actuating a sound select switch 12 connected to the sound controller 60.

The output power of a power circuit 64 (obtained from either the battery 19 or the AC adaptor 17 when the power switch 2 is turned on) is supplied to the fluorescent EL plate (back light) 26 via an inverter circuit 63. The luminous intensity of the fluorescent EL plate 26 can be changed in two steps (e.g., to a value suited for a light room or to another value suited for a drak room) by selectively changing the switch 11. In addition, the luminous intensity of the LCD unit 22 can be controlled to a desired value by controlling the luminance adjust switch 3 separately from the above procedure. A switch 65a is turned on or off in accordance with whether the battery 19 loaded in the main body 1 is a primary battery or a secondary one. Meanwhile a switch 65b is turned on or off in accordance with the detected capacity of the battery 19. The switches 65a and 65b are connected to a key interface 62 via the power circuit 64. To the key interface 62, there are also connected the aforementioned luminance adjust switch 3, select switch 11 and halt switch 13. The key interface 62 supplies to the CPU 41 a signal corresponding to each on-off action of these switches.

An IC card 70 is connected to the socket 14 so that the CPU 41 is capable of transferring any data and program to or from the IC card 70 via an IC card interface 66. An adaptor 71 is connected to the sockets 15 and 16 in a manner to be further connected to the CPU 41 via an extension interface 68.

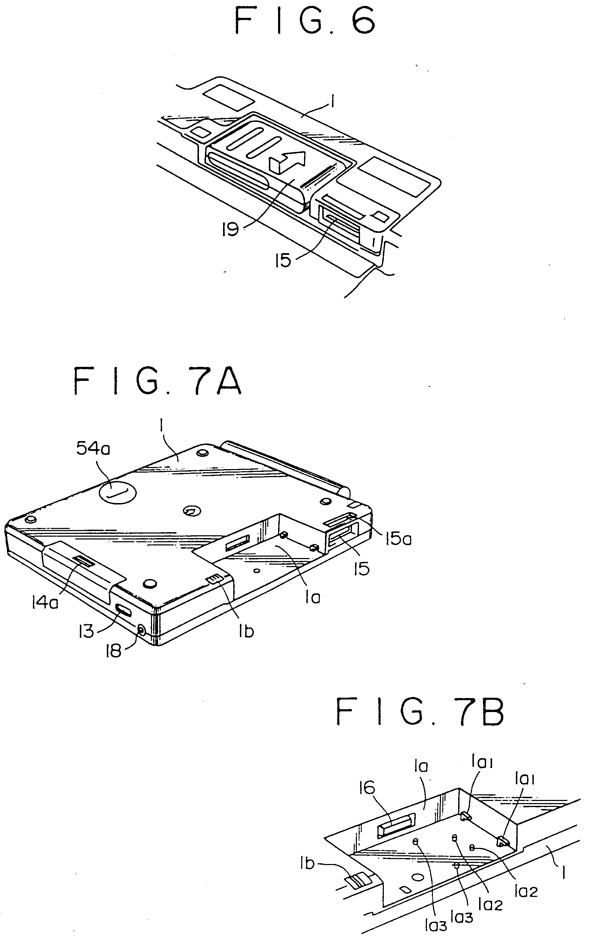

Fig. 6 illustrates a state where the battery 19 is loaded in the main body 1.

Fig. 7A is a perspective bottom view seen from behind with the battery 19 removed from the main body 1 in Fig. 1. A loading compartment 1a is formed in a rear portion of the main body 1 so as to load the battery therein, and an opening 54a is formed for inserting a back battery 54. The socket 14 for loading the memory card 70 is covered with a cover member 14a. And in the vicinity of the socket 15, there is provided a button 15a used when attaching or detaching an unshown connector.

Fig. 7B is an enlarged perspective view of the loading compartment 1a, in which there are disposed electrodes 1a2 for electrically connecting the battery 19, and pins 1a3 for detecting the kind of the battery 19. On side walls of the loading compartment 1a, lock claws 1a1 are provided for preventing accidental slip-off of the battery 19 through engagement with lock recesses 19a in the battery 19.

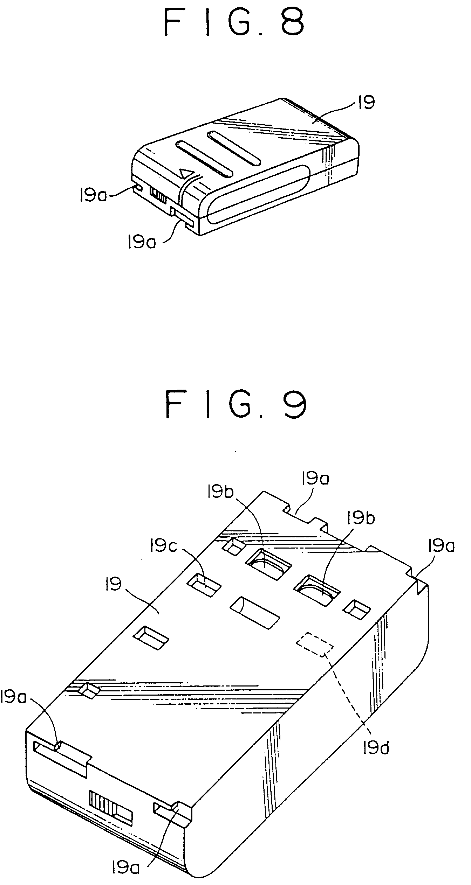

Fig. 8 illustrates the battery 19 removed from the main body 1. The lock recesses 19a engageable with the lock claws 1a1 of the loading compartment 1a are formed at four corners of the bottom surface of the battery 19.

Fig. 9 is a rear view (bottom view) of the battery 19 having the lock recesses 19a at its four corners. Electrodes 19b are disposed at positions corresponding to the electrode 1a2 in the loading compartment 1a. The electrodes 19b and 1a2 are brought into contact with each other to supply a required power from the battery 19 to the main body 1. And a detection aperture 19c is formed in the vicinity of the electrode 19b. The detection aperture 19c is formed in case the battery is of a rechargeable secondary type, and is not formed in a non-rechargeable primary battery. On the right of the detection aperture 19c in Fig. 9, another detection aperture 19d is formed in case the battery capacity is great. Since the battery 19 illustrated in Figs. 8 and 9 is of a secondary type, a detection aperture 19c is formed. However, a detection aperture 19d is not formed as the battery capacity is small. Such detection apertures 19c, 19d are detected by the pin 1a3 disposed in the loading compartment 1a. Denoted by 1b is a button used when loading or unloading the battery 19.

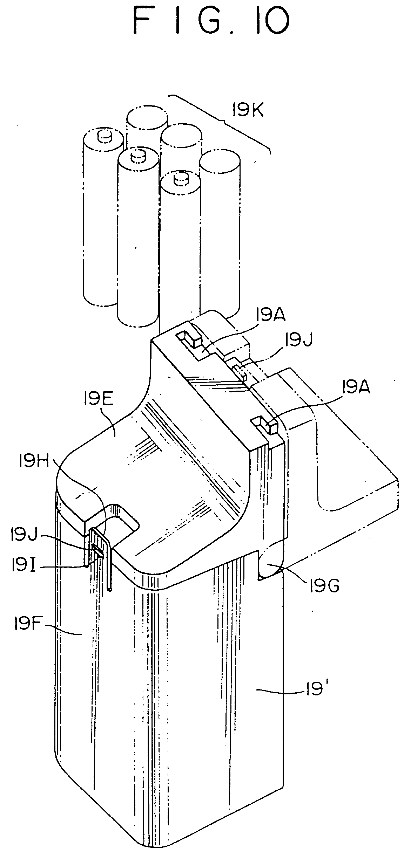

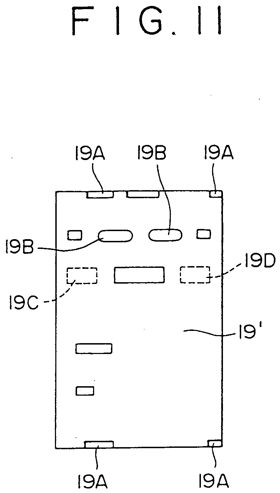

Batteries loadable in the main body 1 are classified into a non-rechargeable primary battery (shown in Figs. 10 and 11 to be described later) containing ordinary dry cells, and a rechargeable secondary battery (shown in Figs. 8 and 9). These batteries are the same in external shape (particularly in bottom shape) so as to be loadable in the main body 1.

Fig. 10 illustrates a primary battery 19' containing primary cells 19K (e.g., six size-AA dry cells). The battery 19' is composed of a lower case 19F and an upper case 19E rotatable on a support hinge 19G. The lower case 19F has a tongue 19H with grooves formed on its both sides so as to be elastically deformable, and a slit 19I formed in the tongue 19H. Meanwhile the upper case 19E has a projection 19J engageable with the slit 19I in the tongue 19H.

Fig. 11 is a bottom view of the primary battery 19'. In comparison with the secondary battery 19 shown in Fig. 9, lock recesses 19A and electrodes 19B are formed correspondingly to the aforementioned lock recesses 19a and electrodes 19b. Due to the primary battery, none of detection apertures 19C and 19D is formed.

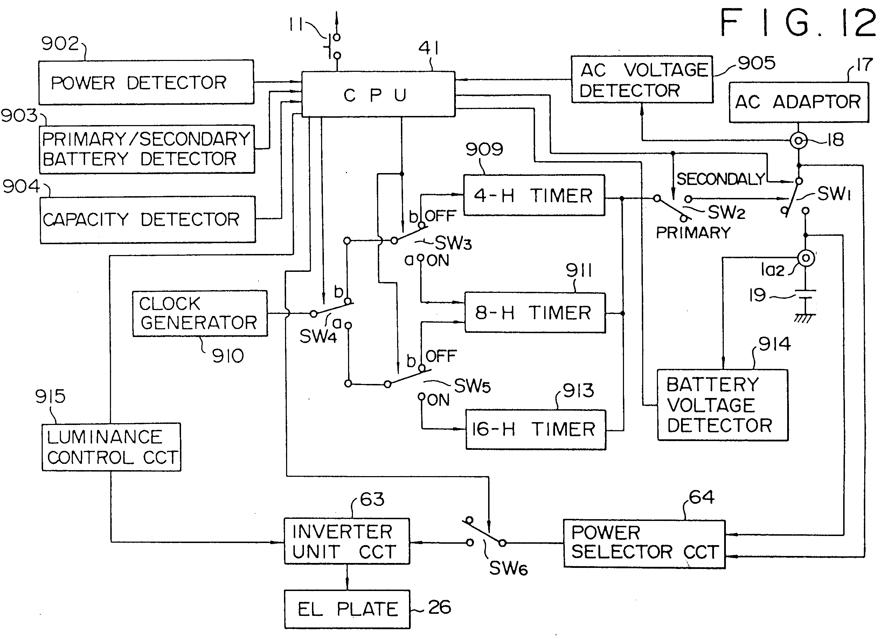

Fig. 12 is a block diagram of an exemplary embodiment representing the data input and display apparatus of the present invention. In this diagram, a power detector 902 detects whether the power switch 2 in the main body 1 is at its on-position or not, and a battery detector 903 detects by the pin 1a3 whether the loaded battery 19 is of a primary type or a secondary type. Further a capacity detector 904 detects by the pin 1a3 whether the capacity of the loaded battery is great or small.

The output of each of such detectors is supplied to the CPU 41.

Meanwhile the converted DC voltage from an AC adaptor 17 is supplied to a terminal 18 provided in the main body 1. For distinction from the battery voltage supplied from the battery 19, the voltage supplied to the terminal 18 is termed "AC voltage" here. The AC voltage thus supplied is compared with a predetermined reference voltage in an AC voltage detector 905, and the result of such comparison is supplied to the CPU 41.

The voltage supplied from the battery 19 via the electrode 1a2 is compared with a predetermined reference voltage in a battery voltage detector 914, and the result of such comparison is supplied to the CPU 41.

Either the AC voltage obtained from the socket 18 or the battery voltage from the electrode 1a2 is selected by a power circuit 64 having a selector therein, and then the selected voltage is supplied from the power circuit 64 to the entire apparatus. This voltage is supplied to an inverter circuit 63 for driving the fluorescent EL plate 26 as a back light via a switch SW6 which serves as one of luminance control means. The inverter circuit 63 is controlled by a command from a luminance control circuit 915 which is one of the luminance control means for controlling the luminous intensity of the fluorescent EL plate 26.

The AC voltage is supplied to the loaded battery 19 via the switch SW1. The switch SW1 is turned on or off under control in accordance with the output of one of a 4-H (hour) timer 909, an 8-H timer 919 or a 16-H timer 913 supplied via the switch SW2.

Such 4-H timer 909, 8-H timer 911 and 16-H timer 913 each consists of a counter which counts up the clock pulses fed thereto from a clock generator 910, and produce a control signal indicative of a count-up termination after the lapse of 4 hours, 8 hours and 16 hours, respectively. The clock pulses from the clock generator 910 are fed to the timer selected by the switches SW4 and SW3 or the switches SW4 and SW5 turned on or off under control of the CPU 41. The time periods preset in the individual timers mentioned above are mere examples and are not limited to such numerical values alone.

Now a description will be given on the operation performed in the data input and display apparatus of the above constitution.

First, when the AC voltage is supplied from the terminal 18, the power circuit 64 selects it by priority and supplies to the switch SW6 a voltage produced on the basis of the selected voltage. In case the AC voltage is not supplied and the battery voltage alone is existent, a voltage produced from the battery voltage is supplied to the switch SW6. The power circuit 64 may be so formed as to selectively output, under control of the CPU 41, a higher one of the AC voltage and the battery voltage.

The on-off action of the switch SW6 is controlled by the CPU 41. If the supplied voltages are both detected to be lower than the predetermined reference voltage by the AC voltage detector 305 and the battery voltage detector 914, the CPU 41 turns off the switch SW6 so as not to supply the power to the inverter circuit 63 serving to drive the fluorescent EL plate 26, which is thereby deenergized.

When at least either the AC voltage or the battery voltage is higher than the reference voltage, the CPU 41 controls the inverter circuit 63 via the luminance control circuit 915 in accordance with the changed state of the luminance selector switch 11, thereby adjusting the luminous intensity of the fluorescent EL plate 26 to its full luminance or half luminance. Furthermore the CPU 41 controls the luminance control circuit 915 in such a manner that the full luminance is attained if the AC voltage is higher than the reference voltage or a secondary battery is loaded even though no AC voltage is supplied, and the half luminance is attained in case no AC voltage is supplied and a primary battery is loaded.

Due to such luminance control executed by the switch SW6 and the luminance control circuit 915, the back light is switched off when the supplied voltage is lower than the reference voltage, or the back light is controlled to its half luminance in case the supplied voltage is obtained from a primary battery, whereby the power consumption relative to the non-rechargeable primary battery can be minimized.

The operation for charging a secondary battery will be described below.

When the loaded battery is detected to be a primary one by the battery detector 903, the switch SW2 is turned off by the CPU 41. On the other hand, if the loaded battery is detected to be a secondary one by the battery detector 903, the switches SW1 and SW2 are turned on by the CPU 41. In this stage, the switch SW1 is kept in its on-state to continue charging the battery during the time period in which the timer 909, 911 or 913 produces an output signal indicative of a clock counting action.

The required charge time is determined in conformity with the 4-H timer 909, the 8-H timer 911 or the 16-H timer 913 selected in accordance with the capacity of the loaded secondary battery and the on-off state of the power supply for the main body 1.

Mere specifically, the CPU 41 discriminates between the on-state and the off-state of the power supply for the main body 1 from the output of the power supply detector 902, and then changes the switches SW3 and SW5 to terminals ON in response to the on-state of the power supply for the main body 1, or changes the same switches to terminals OFF in response to the off-state of the power supply. Furthermore the capacity of the loaded secondary battery is detected to be great or small by the capacity detector 904, and the CPU 41 changes the switch SW4 to a terminal $\underline{a}$ for a great capacity or to a terminal $\underline{b}$ for a small capacity.

When the power supply for the main body 1 is in the on-state, the AC voltage is supplied also to the other circuits in the main body 1, so that a relatively long time is required for charging the battery. However, if the power supply for the main body 1 is in the off-state, the AC voltage is usable solely for charging the secondary battery, hence shortening the required charge time. Therefore the apparatus is so contrived that, in a combination of the 4-H timer 909 and the 8-H timer 911 or in a combination of the 8-H timer 911 and the 16-H timer 913, one timer of the shorter time period in each combination is selected during the power-off state by the switches SW3 and SW5, while the other timer of the longer time period is selected during the power-on state.

In case the secondary battery has a great capacity, the required charge time is naturally long. Therefore the switch SW4 is so changed as to employ the 4-H timer 909 or the 8-H timer 911 for a small capacity or to employ the 8-H timer 911 or the 16-H timer 913 for a great capacity.

When clock pulses are supplied from the clock generator 910 to one of the timers via the switches SW4 and SW3 or the switches SW4 and SW5, the selected timer starts counting up the clock pulses. And upon arrival of the count at the value preset in the timer, a control signal indicative of a count-up termination is fed to the switch SW1 via the switch SW2, so that the switch SW1 is opened by the control signal to thereby prevent overcharge of the secondary battery.

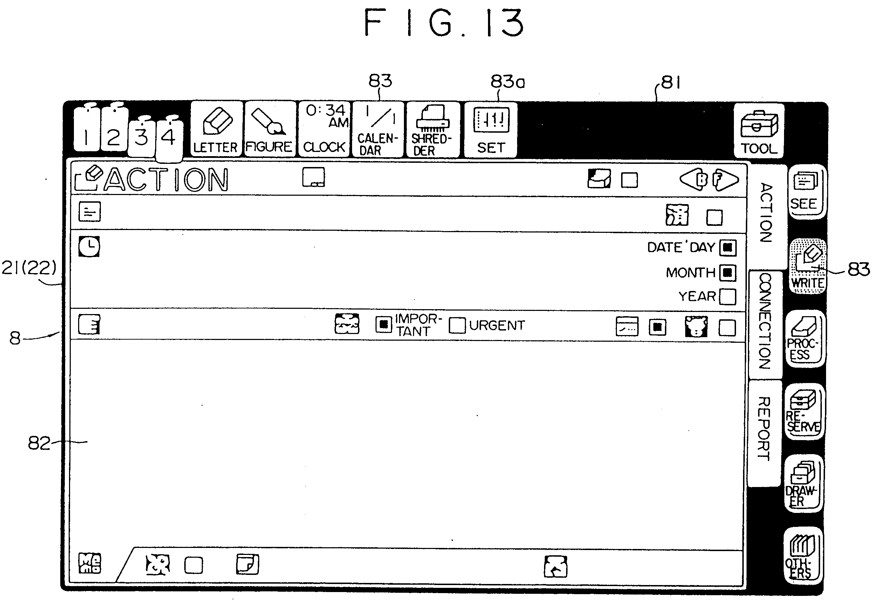

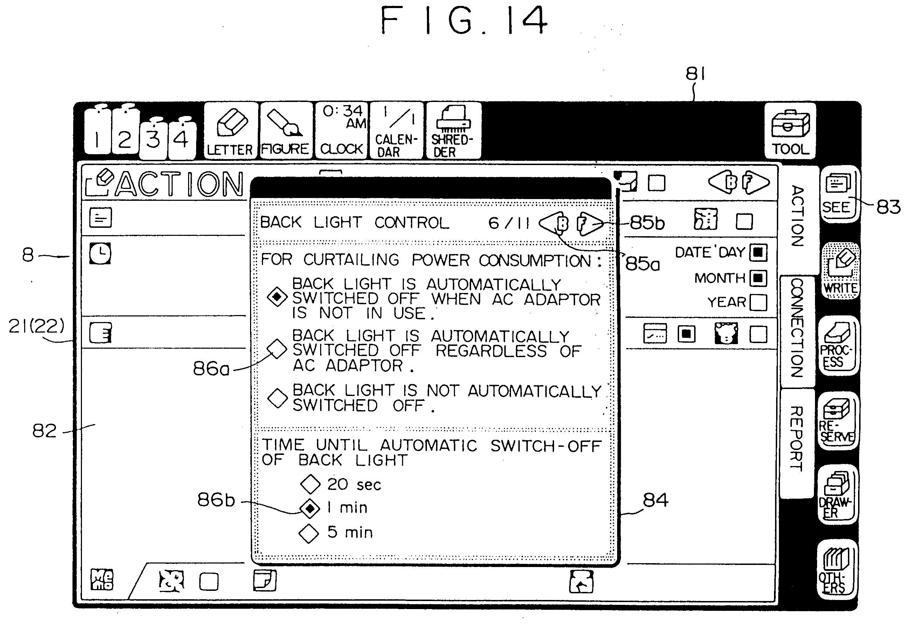

For the purpose of preventing any unnecessary power consumption, this embodiment is so contrived that the fluorescent EL plate 26 (back light) is automatically switched off when no input is fed continuously for more than a predetermined time. Now the procedure to execute such setting will be described below. Fig. 13 shows a display example on the screen 8, where a variety of icons 83 are visually represented in an icon display region 81. Meanwhile desired character rows can be written in an input display region 82 in accordance with a predetermined input. In the state of Fig. 13, if the pen 6 pressed first to the icon "set" 83a is drawn out to the input display region 82 and then is released therefrom, a setting change icon 84 is displayed in an enlarged size as shown in Fig. 14. The setting change icon 84 in this embodiment is composed of 11 pages, and upon touch of the pen 6 with a button 85a or 85b, the display contents can be turned over backward or forward page by page. Fig. 14 shows exemplary display contents of the 6th page which is used for control of the back light. For the purpose of curtailing the power consumption, any of the following three modes can be selected by holding the pen 6 in touch with a button 86a corresponding to the desired mode.

(1) A mode for automatically switching off the back light when the AC adaptor 17 is not connected;

(2) A mode for automatically switching off the back light regardless of connection or non-connection of the AC adaptor 17; and

(3) A mode for not switching off the back light automatically.

This embodiment represents an exemplary case where the mode (1) is selected. A time of 20 seconds, 1 minute or 5 minutes elapsing until automatic switch-off of the back light can be selected by holding the pen 6 in touch with the button 86b corresponding to the desired time. In the embodiment, a time of 1 minute is selected. More specifically, if no input is fed to the tablet 21 by the pen 6 for more than 1 minute with the adaptor 17 not connected, it follows that the back light (fluorescent EL plate 26) is automatically switched off.

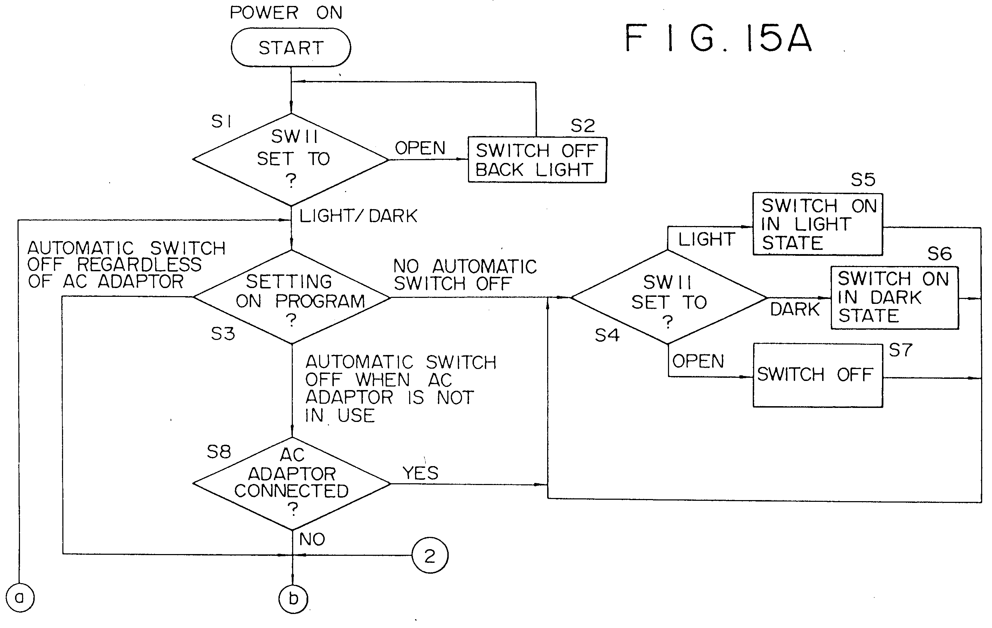

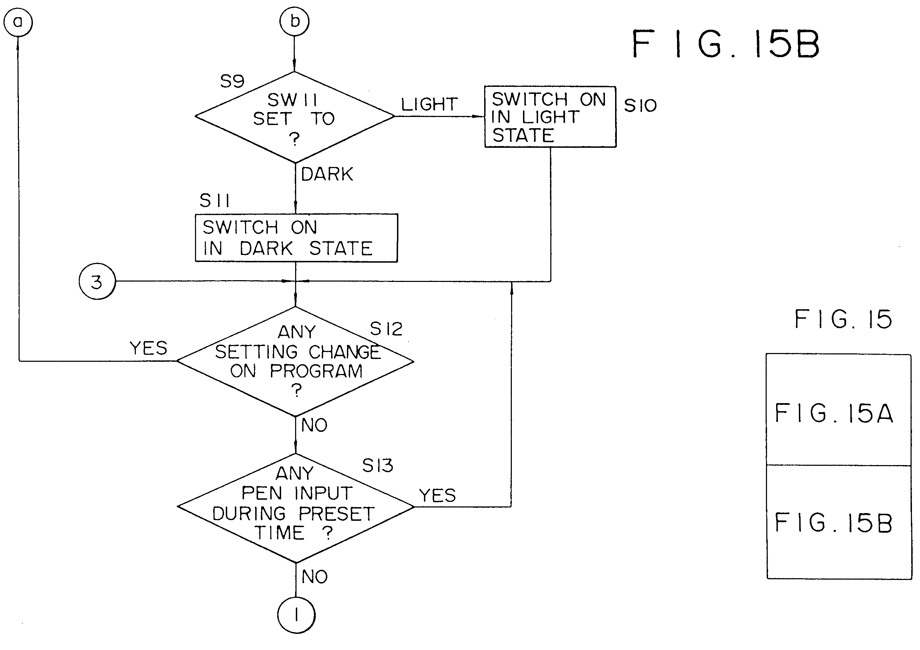

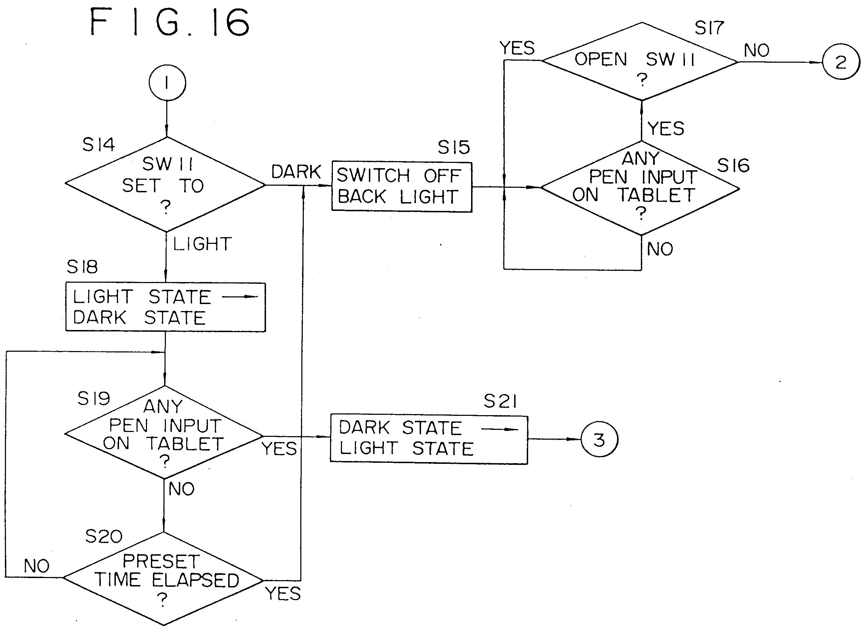

Hereinafter the procedure for controlling the back light will be described with reference to Figs. 15 and 16.

First, when the power switch 2 is turned on, a decision is made in step S1 as to the set state of the switch 11. The switch 11 is capable of selectively designating one of the three modes which signify an off-state where the fluorescent EL plate 26 is not lit, a light (high) state at a high luminous intensity, and a dark (low) state at a low luminous intensity. When the switch 11 is set for selection of the off-state, the operation proceeds to step S2 so that the fluorescent EL plate 26 is not switched on. In case the switch 11 is set for selection of the light or dark state, the operation proceeds to step S3 where a decision is made as to the setting on the program. The setting on the program signifies, as described with reference to Fig. 14, the mode for automatically switching off the back light when the AC adaptor 17 is not connected, the mode for automatically switching off the back light regardless of connection or non-connection of the AC adaptor 17, or the mode for not switching off the back light automatically. In case the selected mode is the third one for not switching off the fluorescent EL plate 26 automatically, the operation proceeds to step S4 where a decision is made as to the mode of the switch 11 again. If the switch 11 is changed to selection of the light state, the operation proceeds to step S5 so that the CPU 41 controls the fluorescent EL plate 26 via the inverter circuit 63 to light up the fluorescent EL plate 26 at a high luminous intensity. Meanwhile, if the switch 11 is changed to the dark state, the operation proceeds to step S6 so that the fluorescent EL plate 26 is lit at a low luminous intensity. In case the switch 11 is set for selection of the off-state, the operation proceeds to step S7 so that the fluorescent EL plate 26 is not switched on. If the set mode is the one for not switching off the fluorescent EL plate 26 automatically, the processes in the steps S4 through S7 are executed repeatedly. And when the switch 11 is changed, the fluorescent EL plate 26 is turned on to be light or dark or is turned off in conformity with the set state of the switch 11.

If the automatic switch-off mode is set on the program with non-connection of the AC adaptor 17, the operation proceeds to step S8 where a decision is made as to whether the AC adaptor 17 is connected or not. If the result of such decision signifies connection of the AC adaptor 17, the automatic switch-off is not performed and therefore the operation proceeds to step S4, and the fluorescent EL plate 26 is turned on to be light or dark or is turned off in conformity with the set state of the switch 11 as mentioned.

If the AC adaptor 17 is not connected in case the automatic switch-off mode regardless of connection or non-connection of the AC adaptor 17 is set on the program or in case the automatic switch-off mode with non-connection of the AC adaptor 17 is set on the program, then the operation proceeds to step S9 where a decision is made as to the set state of the switch 11. Since the operation has advanced to the process posterior to step S3 as a result of the decision in step 1 signifying a change of the switch 11 to the light or dark state, a decision is made in step S9 as to whether the switch 11 is set for selection of the light or dark state. If the result of such decision signifies the light state, the operation proceeds to step S10 to light up the fluorescent EL plate 26 at a high luminous intensity. Meanwhile, if the result of such decision signifies the dark state, the operation proceeds to step S11 to light up the fluorescent EL plate 26 at a low luminous intensity. In either case the operation subsequently proceeds to step S12 where a decision is made as to whether any setting change is existent or not on the program. When there exists no setting change on the program, the operation proceeds to step S13 where a decision is made as to whether the pen 6 has been brought down to the tablet 21 within the preset time (20 seconds, 1 minute or 5 minutes). In an example where the preset time is 1 minute, the processes of steps S12 and S13 are repeated if the lapse of time after the final pen-up action from the table 21 is less than 1 minute. And if any setting is changed on the program during such processes, the operation reverts to step S3, and then the processes posterior thereto are executed.

In case the pen-down action onto the tablet 21 is not performed for more than the preset time after the final pen-up action, the operation proceeds to step S14 where a decision is made as to the set state of the switch 11. If the result of such decision signifies the dark state selected by the switch 11, the operation proceeds to step S16 where a decision is made as to whether the pen 6 has been brought down to the tablet 21. And in case the pen-down action onto the tablet 21 has not been performed, the process of step S16 is executed repeatedly. Therefore, even if the switch 11 is changed to select the light or dark state during the above process, such change is ignored and the fluorescent EL plate 26 is maintained in its off-state. For achieving an escape from this loop (off-state), it is necessary to perform a pen-down action of touching the tablet 21 with the pen 6. And after the pen-down action, the operation proceeds from step S16 to step S17 where a decision is made as to whether the switch 11 has been turned off or not. More specifically, if the user changes the switch 11 to select the off-state in the standby mode of step S16, the operation reverts to step S16 again where a decision is made as to whether the pen 6 has been brought into touch with the tablet 21. As a result, if the switch 11 is changed to its off-position in the off-state of the fluorescent EL plate 26 after the lapse of the preset time, the fluorescent EL plate 26 is maintained in the off-state even with the pen-down action onto the tablet 21. In case the result of the decision in step S17 indicates a change of the switch 11 to the light or dark position, the operation reverts to step S9 so that the fluorescent EL plate 26 is switched on to be light or dark in conformity with the set state of the switch 11.

Meanwhile, if the result of the decision in step S14 indicates the light state selected by the switch 11 to signify that the switch 11 has been set for designating the light state with no input fed from the pen 6 for more than the preset time, then the operation proceeds to step S18 so that the on-state of the fluorescent EL plate 26 is changed from the light state to the dark state. Consequently the luminous intensity of the fluorescent EL plate 26 is lowered. Thereafter the operation proceeds to step S19 where a decision is made as to whether any input from the pen 6 is existent or not on the tablet 21. In case there is no input, the operation proceeds to step S20 where a decision is made as to whether the preset time has elapsed or not. If the lapse has not yet reached the preset time, the operation reverts to step S19 where a decision is made again as to the presence or absence of any pen input on the tablet 21. In case any input from the pen 6 is not existent on the tablet 21 within the preset time, the operation reverts to step S15 so that the fluorescent EL plate 26 is switched off. And then the process posterior to step S16 is executed. If an input is fed from the pen 6 to the tablet 21 before the lapse of the preset time, the operation proceeds to step S21 so that the fluorescent EL plate 26 being lit is changed from the dark state to the light state, and the operation reverts to step S12.

The embodiment mentioned represents an exemplary constitution where, when the switch 11 is set for selection of the light state, the on-state of the fluorescent EL plate 26 is changed from the light state to the dark state if there exists no input from the pen 6 for more than the predetermined time. However, it is merely an example and may be so modified as to change the fluorescent EL plate 26 immediately from the light state to the off-state. This modification is more suited for minimizing any wasteful power consumption relative to the battery.

According to the data input and display apparatus of the present invention, as described hereinabove, a tablet is illuminated by a light source together with a liquid crystal display unit, so that an input screen is rendered light to facilitate a manipulation of inputting desired data even in a dark place.

Furthermore, a detection means is employed for detecting whether a voltage source is an AC power source or a battery, or whether the voltage supplied therefrom is sufficiently higher than a reference voltage, and the luminance of the light source is controlled in accordance with the detection output thus obtained. Therefore, when a battery is used as the voltage source, the power consumption in the light source can be minimized to consequently prolong the service life of the battery.

Besides the above, the light source is controlled in accordance with an input fed to the tablet, so that any wasteful power consumption of the loaded battery can be reduced without a dimensional increase of the opparatus structure while averting a rise of the production cost, thereby ensuring a longer life of the battery effectively in practical use.

**Claims**

1.   A data input and display apparatus comprising:
     a tablet (21) to which an information signal is inputted by designating a coordinate position;
     a display circuit (42a, 42b, 43) for generating a display signal in accordance with the information signal inputted from said tablet (21);
     a display member (22) capable of visually representing said display signal;
     a control circuit (46) for generating a control signal by detecting the presence of any input to said tablet (21);
     a light source (26) for illuminating said display member (22) from behind; and
     a light source controller (63) for controlling said light source (26) in response to the control signal generated from said control circuit (46).

2.   The data input and display apparatus according to claim 1, wherein the information signal is inputted to said tablet (21) by means of a pen member (6).

3.   The data input and display apparatus according to claim 1 or 2, wherein said display member (22) is a liquid crystal display member, and said light source (26) is disposed behind said liquid crystal display member while said tablet (21) is superposed on the front thereof so that the display signal visually represented on said display member (22) is rendered visible through said tablet (21).

4.   The data input and display apparatus according to anyone of claims 1 to 3, further comprising a means (62) for previously setting a desired on-state of said light source.

5.   The data input and display apparatus according to claim 4, wherein said setting means includes a switch (3) for determining the initial on-state of said light source (26).

6.   The data input and display apparatus according to anyone of claims 1 to 5, wherein said light source controller (63) is so controlled as to select either an on-state of said light source (26) or an off-state thereof.

7.   The data input and display apparatus according to claim 6, wherein said control circuit (46) detects the absence of any input to said tablet (21) during a predetermined time and, in response to the result of such detection, controls said light source controller (63) in such a manner as to change the on-state of said light source (26) to the off-state thereof.

8.   The data input and display apparatus according to claim 6 or 7, wherein the on-state of said light source (26) includes a first or light state of said light source (26) and a second or dark state thereof.

9. The data input and display apparatus according to claim 8, wherein said control circuit (46) detects the absence of any input to said tablet (21) during a predetermined time and, in response to the result of such detection, controls said light source controller (63) in such a manner as to change said first state to said second state.

10. The data input and display apparatus according to claim 4, wherein said setting means is shown in a setting window (84) displayed on said display member (22), and the setting is executed by designating a desired item in said window (84).

11. The data input and display apparatus according to anyone of claims 7 to 10, further having a means capable of selectively setting said predetermined time.

12. The data input and display apparatus according to anyone of claims 7 to 11, wherein the state after the lapse of said predetermined time is canceled by a next information input to said tablet (21).

13. A data input and display apparatus comprising:
   an input means for inputting an information signal;
   a display circuit (42a, 42b, 43) for generating a display signal in accordance with the information signal obtained from said input means;
   a display member (22) capable of visually representing said display signal;
   a control circuit (46) for generating a control signal by detecting the presence of any input to said input means;
   a light source (26) for illuminating said display member from behind;
   a light source controller (63) for controlling said light source (26) in response to the control signal generated from said control circuit (46);
   a power circuit (64) for obtaining a driving voltage from a voltage source;
   a means for detecting (905, 914) the state of said voltage source; and
   a luminance control means (915) for controlling the luminance of said light source (26) in response to the output of said detecting means (905, 914);
   wherein said power circuit (64) is capable of selecting, as said voltage source, either a first voltage produced by rectifying an AC power supply (17), or a second voltage obtained from a battery (19).

14. The data input and display apparatus according to claim 13, wherein said input means is a tablet (21) to which an information signal is inputted by designating a coordinate position.

15. The data input and display apparatus according to claim 13 or 14, wherein said luminance control circuit (915) is so controlled, in response to the output of said detecting means (905, 914), as to select either an on-state of said light source or an off-state thereof.

16. The data input and display apparatus according to anyone of claims 13 to 15, wherein said luminance control circuit (915) detects the absence of any input to said tablet (21) during a predetermined time and, in response to the result of such detection, controls said light source controller (63) in such a manner as to change the on-state of said light source (26) to the off-state thereof.

17. The data input and display apparatus according to anyone of claims 13 to 16, wherein the on-state of said light source (26) includes a first or light state of said light source (26) and a second or dark state thereof.

18. The data input and display apparatus according to anyone of claims 13 to 17, wherein said luminance control circuit (915) detects the absence of any input to said tablet (21) during a predetermined time and, in response to the result of such detection, controls said light source controller (63) in such a manner as to change said first state to said second state.

19. The data input and display apparatus according to anyone of claims 13 to 18, wherein said control circuit (46) has a setting means which detects the absence of any input to said input means (21) during a predetermined time and, when said first voltage is not used, selects a mode to switch off said power source automatically in response to the result of such detection.

20. The data input and display apparatus according to claim 19, wherein said setting means detects the absence of any input to said input means (21) during a predetermined time and, regardless of the use of said first voltage, selects a mode to switch off said power source automatically in response to the result of such detection.

21. The data input and display apparatus according to claim 20, wherein said setting means is further capable of setting a mode not to switch off said power source automatically even when the result of the detection signifies the absence of any input to said input means (21) during said predetermined time.

22. The data input and display apparatus according to anyone of claims 16 to 21, further comprising a means for selectively setting said predetermined time.

23. The data input and display apparatus according to anyone of claims 16 to 22, wherein the state after the lapse of said predetermined time is canceled by a next information input to said tablet (21).

F I G. 1

# F I G. 2

# F I G. 3

EP 0 496 383 A2

# F I G. 4

14

FIG. 5

# F I G. 6

19
15

# F I G. 7A

54a
1
15a
15
14a
13
18
1a
1b

# F I G. 7B

16
1a
1a1
1a1
1b
1
1a2
1a2
1a3
1a3

# F I G. 8

# F I G. 9

# F I G. 10

# F I G. II

FIG. 12

EP 0 496 383 A2

# F I G. 13

EP 0 496 383 A2

# F I G. 14

POWER ON

FIG. 15A

EP 0 496 383 A2

FIG. 15B

FIG. 15

| FIG.15A |
|---|
| FIG.15B |

S9 SW11 SET TO ?

LIGHT

DARK

SWITCH ON IN LIGHT STATE  S10

S11 SWITCH ON IN DARK STATE

S12 ANY SETTING CHANGE ON PROGRAM ?

YES

NO

3

S13 ANY PEN INPUT DURING PRESET TIME ?

YES

NO

b

a

1

# F I G. 16

S14 SW II SET TO ?

DARK

S15 SWITCH OFF BACK LIGHT

S17 OPEN SW II ? — NO → ② / YES

S16 ANY PEN INPUT ON TABLET ? — YES / NO

LIGHT

S18 LIGHT STATE → DARK STATE

S19 ANY PEN INPUT ON TABLET ? — YES → S21 DARK STATE → LIGHT STATE → ③

NO

S20 PRESET TIME ELAPSED ? — NO / YES

EP 0 496 383 A2